# EUROPÄISCHE PATENTSCHRIFT

(11) **EP 2 068 399 B1**
(45) Veröffentlichungstag und Bekanntmachung des Hinweises auf die Patenterteilung: **25.01.2012**
(21) Anmeldenummer: 08450168.3
(22) Anmeldetag: 24.10.2008
(51) Int. Cl.: H01Q 9/28, H01Q 23/00, G01R 29/08

(54) **Hohlkegelantenne**
Hollow cone aerial
Antenne à cône creux

(30) Priorität: 07.12.2007 AT 19882007
(43) Veröffentlichungstag der Anmeldung: 10.06.2009
(73) Patentinhaber: Seibersdorf Labor GmbH, 2444 Seibersdorf (AT)
(72) Erfinder: Müllner, Wolfgang, Dipl.-Ing., 2486 Landegg (AT); Haider, Harald, Dipl.-Ing., 1110 Wien (AT)
(74) Vertreter: Wildhack & Jellinek

(56) Entgegenhaltungen:
- WO-A-01/45206
- WO-A-85/03169
- W. MÜLLNER: "REFRAD X" PRODUCT INFOSHEET, [Online] XP002510919 Seibersdorf RF Website Gefunden im Internet: URL:http://www.seibersdorf-rf.com/docs/lea flet/W_Products_RefRad_X_engl.pdf> [gefunden am 2009-03-06]

## Beschreibung

Die Erfindung betrifft eine Antenne gemäß dem Oberbegriff des Anspruches 1.

Derartige Antennen werden im Bereich der elektromagnetischen Verträglichkeitsmessung, insbesondere zur Kalibrierung von Messanlagen zur elektromagnetischen Verträglichkeitsprüfung eingesetzt.

Aus der internationalen Patentanmeldung WO 01/45206 A1 ist eine Antennenanordnung bekannt, die zweiteilig ausgebildet ist und zwei kegelstumpfförmige Antennenelemente aufweist. Weiters ist das Dokument XP-002510919 bekannt, das einen Kammgenerator mit einer Antennenanordnung darstellt, wobei die Antennenanordnung zwei hohlkegelförmige Teile umfasst, die durch ein zentrales Verbindungsstück mit einander in Verbindung stehen.

Weiters ist aus der internationalen Patentanmeldung WO 85/03169 A eine doppelt konische Hohlkegelantenne bekannt, wobei die hohlkegelförmigen Antennenteile im Scheitelbereich miteinander verbunden sind, entsprechend der Präambel des Anspruchs 1.

Aufgabe der Erfindung ist die einfache und kostengünstige Konstruktion einer doppelt konischen Dipolantenne zur Emission hochsymmetrischer und hochgenauer elektromagnetischer Felder bzw. Wellen. Wesentlich für eine derartige Antenne ist der exakte rotationssymmetrische und konische Aufbau, das Verhindern bzw. das Unterdrücken von elektrischen Störeinflüssen, insbesondere im Nahebereich der Antenne, sowie ein einfacher elektrischer und mechanischer Aufbau mit hoher Stabilität und einfacher Handhabung. Die Erfindung hat somit das Ziel, eine Antenne zu erstellen, die diesen Anforderungen entspricht.

Die Erfindung löst diese Aufgabe mit den Merkmalen des Kennzeichens des Anspruches 1.

Durch die Erfindung wird eine Vorrichtung geschaffen, welche diesen Ansprüchen gerecht wird und einen stabilen zweiteiligen Aufbau einer doppelt konischen, achssymmetrischen Antenne gewährleistet. Durch diesen erfindungsgemäßen Aufbau ist es ferner möglich, im Bereich des Scheitelpunktes eine ausreichende Stabilität bei geringen Feldverzerrungen zu erzielen.

Ein einfacher Aufbau einer Hohlkegelantenne mittels zweier Antennenteile wird erfindungsgemäß gewährleistet, wenn der Verbindungsteil die Außenform eines Kegels aufweist und den zweiten Antennenteil kegelstumpfförmig verlängert bzw. fortsetzt.

Die Merkmale, dass an jedem der beiden Antennenteile je eines von zwei elektrischen Verbindungselemente angeordnet ist, wobei das erste elektrische Verbindungselement elektrisch leitend mit dem zweiten elektrischen Verbindungselement sowie mit dem Mantel des ersten Hohlkegels verbunden ist und/oder dass an jedem der beiden Antennenteile mechanische Verbindungselemente vorgesehen sind, welche die beiden Antennenteile in ihrer gegenseitigen Position zueinander festlegen und/oder dass die mechanischen Verbindungselemente und/oder die elektrischen Verbindungselemente rotationssymmetrisch bezüglich der Achse der Hohlkegel aufgebaut sind, vereinfachen die Führung eines das Antennensignal führenden Signalkabels im Bereich des Scheitelpunktes sowie zwischen den beiden Antennenteilen bzw. ermöglichen einen einfachen Aufbau sowie eine präzise Außenform der Antenne. Eine derartige Antenne ist einfach herzustellen und ermöglicht eine Verbindung der beiden Antennenteile zu einer eine präzise geometrische Form aufweisenden Antenne.

Vorteilhafte Möglichkeiten zur mechanischen Verbindung der beiden Antennenteile sind dann gegeben, wenn die mechanischen Verbindungselemente an den einander zugewandten Flächen bzw. Seiten der Antennenteile angeordnet sind und gegebenenfalls als aneinander angepasste Schraubverbindungen mit Innen- bzw. Außengewinde ausgebildet sind und/oder wenn die mechanischen Verbindungselemente als Rastverbindung mit Rastelement und Rastausnehmung ausgebildet sind und/oder wenn der zweite Antennenteil, die mechanischen Verbindungselemente und der Verbindungsteil elektrisch leitend verbunden sind. Bei einer derartigen Antenne liegt das Potenzial an allen Punkten des ersten Hohlkegels auf Massepotenzial.

Eine Antenne kann platzsparend aufgebaut werden, wenn der Verbindungsteil als Stecker oder Buchse zur Leitung eines elektrischen Signals sowie zur Verbindung eines Massekontakts und zur mechanischen Verbindung der beiden Antennenteile ausgestaltet ist und/oder wenn der Verbindungsteil als Verrastteil oder als Rastausnehmung gebildet ist und der am Verbindungsteil anliegenden Seite des zweiten Antennenteils ein an den Verbindungsteil angepasster Verrastteil oder eine entsprechende Rastausnehmung angeordnet bzw. ausgebildet ist und/oder wenn der Verbindungsteil als Schraubstecker, insbesondere mit Außengewinde, oder als an das als Schraubstecker ausgebildete zweite mechanische Verbindungselement angepasste Buchse, insbesondere mit Innengewinde, gebildet ist, und wenn an der am Verbindungsteil anliegenden Seite des zweiten Antennenteils eine an den Verbindungsteil angepasste Buchse oder ein entsprechender Schraubstecker angeordnet bzw. ausgebildet ist. Diese Ausführungsform bietet eine besonders gute elektrische sowie mechanisch stabile Verbindung.

Eine Antenne, bei der vorgesehen ist, dass die beiden aneinander anliegenden oder angrenzenden Flächen der beiden Antennenteile zur Deckung gebracht sind und insbesondere kreisförmig und/oder mit gleich großer End- bzw. Querschnittsfläche ausgebildet sind, weist eine besonders genaue geometrische Form auf und kann zur Abstrahlung genau definierter und hochsymmetrischer elektromagnetischer Wellen herangezogen werden.

Eine Antenne bietet eine besonders einfache Führung des Antennenkabels im Bereich zwischen den beiden Antennenteilen, wenn die elektrischen Verbindungselemente als zwei miteinander verbindbare, insbesondere metallische und/oder zylindrische, Leiterelemente ausgebildet sind, welche insbesondere koaxial bezüglich der Kegelachse A und/oder direkt um die Kegelachse A angeordnet sind und gegenüber dem zweiten Antennenteil isoliert sind.

Eine Antenne weist eine erhöhte Stabilität im Bereich des gemeinsamen Scheitelpunktes auf, wenn die beiden Hohlkegel im Bereich des gemeinsamen Scheitelpunkts eine von der Kegelgestalt abweichende Außenform aufweisen, und in diesem Bereich insbesondere zylindrische Form oder die Form eines Drehhyperboloids aufweisen.

Wenn vorgesehen ist, dass im scheitelpunktnahen Endbereich der beiden Hohlkegel eine durchgehende Ausnehmung parallel zur Symmetrieachse A der Antenne zur Durchführung eines leitfähigen zylindrischen Kontaktstiftes vorgesehen ist, dass das erste elektrische Verbindungselement als Kontaktstift ausgebildet ist, insbesondere aus Metall gebildet ist, durch die Ausnehmung durchgeführt ist, mit dem Mantel des ersten Hohlkegels elektrisch leitend verbunden und gegenüber dem zweiten Hohlkegel isoliert ist, dass der Kontaktstift an seinem dem zweiten elektrischen Verbindungselement zugewandten Ende mit dem am zweiten Antennenteil angeordneten elektrischen Verbindungselement elektrisch leitend verbindbar ist, und dass gegebenenfalls das zweite elektrische Verbindungselement einen angepassten Endbereich, insbesondere eine angepasste Ausnehmung, aufweist, wobei gegebenenfalls an der Wand der Ausnehmung des ersten Hohlkegels eine Isolierungsbeschichtung oder ein isolierender Hohlzylinder angeordnet ist, und/oder im Bereich zwischen den beiden Hohlkegeln Isoliermaterial, insbesondere ein isolierender, vorzugsweise zylindrischer, Ring, insbesondere aus Kunststoff, angeordnet ist, und/oder die beiden einander zugewandten Flächen der beiden Hohlkegel isolierend beschichtet oder mit einer Isolierschicht getrennt sind und/oder im Außenbereich des scheitelpunktnahen Endbereichs der beiden Hohlkegel ein Halterungselement, insbesondere aus Kunststoff, zur Erhöhung der Stabilität der Antenne vorgesehen ist, welches eine Innenform aufweist, welche der Außenform der Hohlkegel entspricht, und an den beiden Hohlkegeln anliegt, wobei gegebenenfalls die Außenform des Halterungselements einem Zylindermantel entspricht und/oder der Durchmesser des zylindrischen Halterungselements im Bereich zwischen dem doppelten bis fünffachen Durchmesser des minimalen Durchmessers des scheitelpunktnahen Endbereichs eines der beiden Hohlkegel liegt, wird eine Führung des Antennenkabels zum zweiten Hohlkegel ohne Verzerrung des abgestrahlten Feldes erreicht. Ferner wird ein Kurzschluss des Antennensignals mit dem Massesignal vermieden und es erfolgt eine Stabilisierung der Antennenkonstruktion im Bereich des Scheitelpunktes. Eine Feldverzerrung durch eine äußere Signalzuleitung wird verhindert, wenn im zweiten Antennenteil ein Kammgenerator zur Erzeugung eines Antennensignals angeordnet ist, wobei gegebenenfalls Batterien zur Stromversorgung des Kammgenerators im zweiten Antennenteil, insbesondere im scheitelpunktnahen Innenbereich des zweiten Hohlkegels, angeordnet sind und/oder wenn der Signalausgang des Kammgenerators an das zweite elektrische Verbindungselement angeschlossen ist, und das Massesignal des Kammgenerators an den zweiten Antennenteil, an eines und/oder beide mechanischen Verbindungselemente und/oder an den Verbindungsteil angeschlossen ist bzw. mit zumindest einem dieser Elemente verbunden ist.

Zur Verhinderung von Feldverzerrungen durch ein elektrisches Stromversorgungskabel kann vorgesehen sein, dass der Kammgenerator auf einer, insbesondere kreisförmigen, an den Innendurchmesser des zweiten Hohlkegels angepassten, Platine angeordnet ist, welche im Inneren des zweiten Hohlkegels, insbesondere an der Innenseite des zweiten Hohlkegels, befestigt ist. Es ergibt sich ferner ein platzsparender Aufbau einer erfindungsgemäßen Antenne mit einem Signalgenerator oder Kammgenerator.

Sofern vorgesehen ist, dass der das erste elektrische Verbindungselement bildende Kontaktstift mit dem ersten Antennenteil, insbesondere dem ersten Hohlkegel, und/oder mit dem zweiten elektrischen Verbindungselement lösbar verbindbar und/oder elektrisch kontaktierbar ist, kann eine Antenne besonders einfach und schnell zusammengesetzt werden.

Eine Sendeantenne umfasst vorteilhaft den zweiten Antennenteil einer Antenne, wobei eine als Antennenpol fungierende Metallkonfiguration mit dem zweiten elektrischen Verbindungselement elektrisch leitend verbunden ist, wobei gegebenenfalls die Metallkonfiguration als gerader, insbesondere zylindrischer, Metallstab ausgebildet ist und/oder Befestigungsmittel, insbesondere Stecker oder Buchsen an der Metallkonfiguration vorgesehen sind, mit welchen das Antennenelement mit dem zweiten elektrischen Verbindungselement elektrisch verbindbar ist, wobei die Signalmasse des Kammgenerators gegebenenfalls mit dem mechanischen Verbindungselement leitend verbunden ist und/oder die Metallkonfiguration durch ein umschirmtes Koaxialkabel gebildet ist, an dessen Ende eine Buchse oder ein Stecker vorgesehen ist, welche mit den Verbindungselementen elektrisch und/oder bewegungsfest verbindbar ist. Diese Merkmale ergeben ein Antennenelement bzw. sehen vor, dass der zweite Antennenteil einer erfindungsgemäßen Antenne mit einem beliebigen Antennenelement verwendet werden kann. Ferner wird eine stabile einfache Verbindung des zweiten Antennenteils mit einem Antennenelement erreicht, wobei eine besonders einfache und kostengünstige Sendeantenne erstellt wird.
Figur 1 zeigt schematisch eine doppelt konische Hohlkegelantenne, die in zwei Antennenteile geteilt ist.
Figur 2 zeigt eine erfindungsgemäße Antenne im zusammengesetzten Zustand.
Figur 3 zeigt den ersten Antennenteil der erfindungsgemäßen Antenne.
Figur 4 zeigt den zweiten Antennenteil der erfindungsgemäßen Antenne.
Figur 5 zeigt den scheitelpunktnahen Übergangsbereich zwischen den beiden Hohlkegeln.
Figur 6 zeigt die Antenne von oben mit einer Schnittebene I-I, die die Symmetrieachse A der Antenne umfasst.
Figur 7 zeigt eine alternative Ausführungsform einer erfindungsgemäßen Antenne, die im Übergangsbereich zwischen den beiden Hohlkegeln mechanisch stabilisiert ist.
Figur 8 zeigt eine Antenne umfassend einen kegelstumpfförmigen Antennenteil, sowie ein mit dem Antennensignal beaufschlagtes Antennenelement.

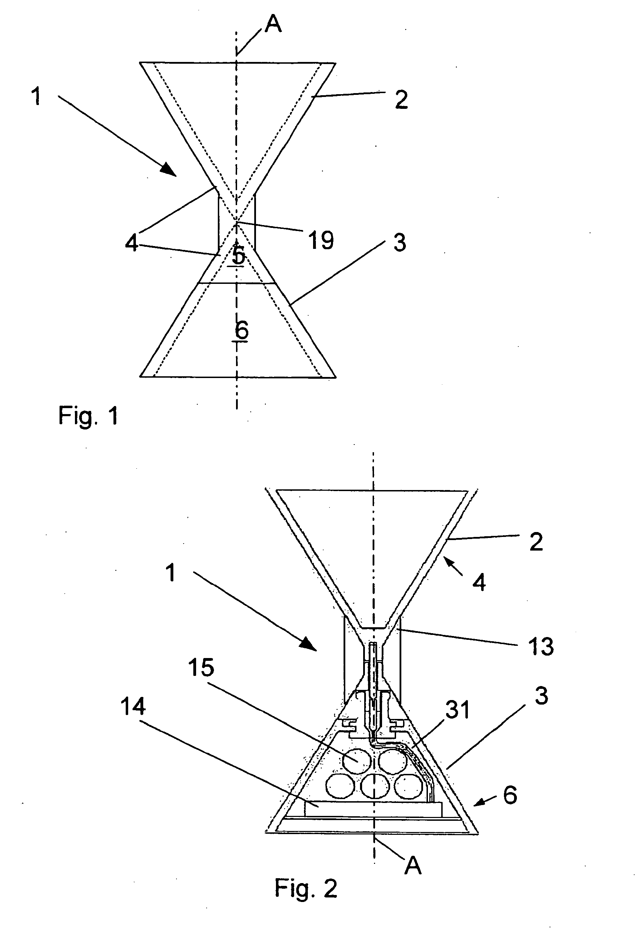

Figur 1 zeigt eine Antenne 1 mit einem ersten Hohlkegel 2 sowie einem zweiten Hohlkegel 3. Die beiden Hohlkegel 2, 3 haben die selbe Symmetrieachse A und den selben Scheitelpunkt 19. Die Hohlkegel 2, 3 sind in entgegengesetzte Richtungen geöffnet und die entsprechenden Öffnungswinkel sind gleich groß. Im Nahebereich des Scheitelpunktes 19 weicht die Form der beiden Hohlkegel 2, 3 von der Kegelform ab und wird zur Erhöhung der mechanischen Stabilität zylindrisch fortgesetzt.

Erfindungsgemäß ist vorgesehen, dass die Antenne 1 mit zwei Antennenteilen 4, 6 gebildet ist. Der erste Antennenteil 4 umfasst hierbei den gesamten ersten Hohlkegel 2 sowie einen kegelförmigen, scheitelpunktnahen Verbindungsteil 5 des zweiten Hohlkegels 3. Der zweite Antennenteil 6 umfasst den übrigen Teil des zweiten Hohlkegels 3.

Figur 2 zeigt die erfindungsgemäße Antenne 1 im zusammengesetzten Zustand. Im zweiten Hohlkegel 3 befindet sich ein zur Erzeugung des abzustrahlenden Signals vorgesehener Kammgenerator 14. Dieser Kammgenerator 14 ist auf einer kreisrunden Platine 16 angeordnet, welche normal auf die Symmetrieachse A der Antenne 1 steht und an die Innenform des zweiten Hohlkegels 3 angepasst ist. Im Bereich des zweiten Antennenteils 6 oberhalb des Kammgenerators 14 bzw. in dem durch den Kammgenerator 14 bzw. die Platine 16 begrenzten Innenraum befindet sich eine Mehrzahl von Batterien 15, Akkumulatoren oder dergleichen zur Versorgung des Kammgenerators 14 mit elektrischer Energie. Diese Batterien 15 sind an den Kammgenerator 14 angeschlossen. An den Kammgenerator 14 ist ferner ein Signalkabel 31 zur Leitung von hochfrequenten, elektrischen Signalen angeschlossen, welches als Koaxialkabel ausgebildet ist und einen Innenleiter sowie einen Außenleiter aufweist.

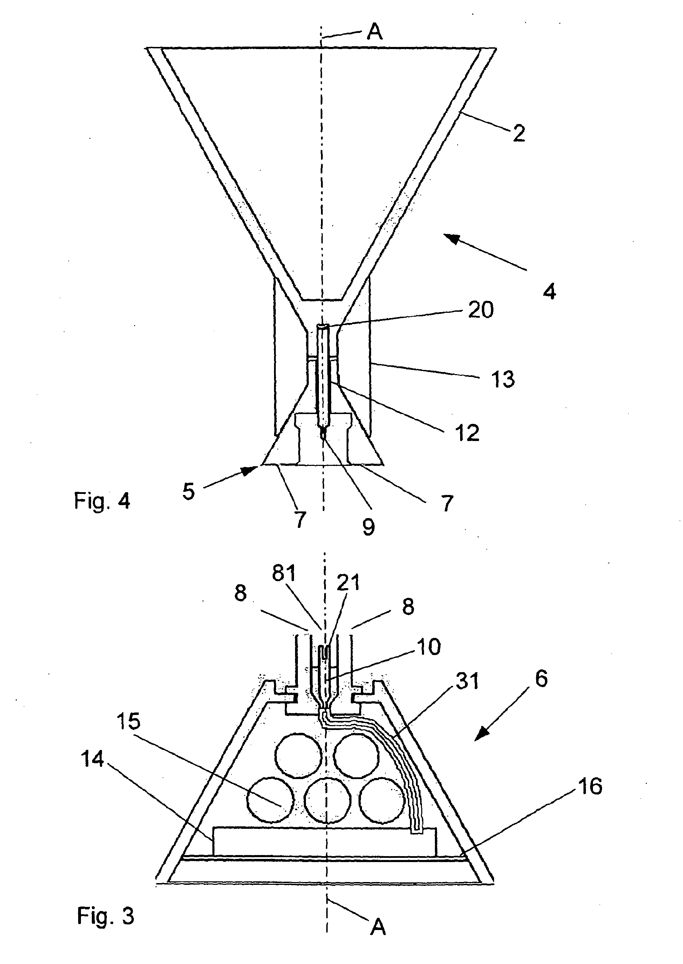

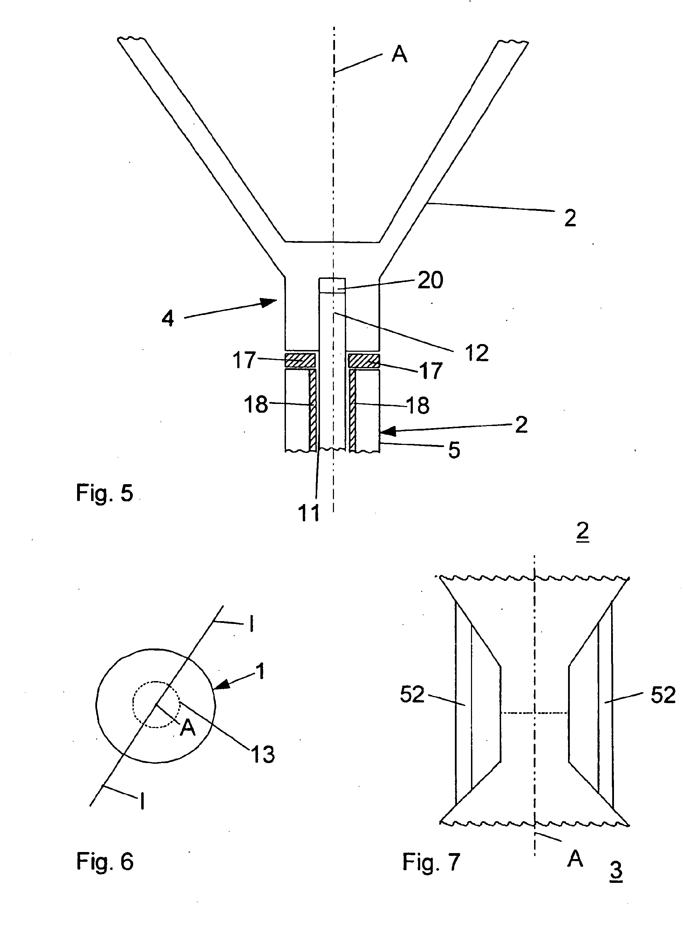

Figur 3 zeigt schematisch einen Schnitt durch den zweiten Antennenteil 6 entsprechend der in Figur 6 dargestellten Ebene I-I verläuft. Im oberen bzw. scheitelpunktnahen Endbereich des zweiten Antennenteils 6 sind ein zweites elektrisches Verbindungselement 10 sowie ein zweites mechanisches Verbindungselement 8 vorgesehen. Das zweite mechanische Verbindungselement 8 kann beispielsweise als Schraubverbindungsteil mit Innen- bzw. Außengewinde oder als Einrastelement oder Rastnut ausgebildet sein. Das zweite mechanische Verbindungselement 8 ist mit Metall oder aus einem anderen leitfähigen Material gebildet und mit dem metallischen Mantel des zweiten Antennenteils 6 leitend verbunden. Das zweite mechanische Verbindungselement 8 weist eine Ausnehmung 81 zur Durchführung des zweiten elektrischen Verbindungselements 10 auf. Dieses zweite elektrische Verbindungselement 10 ist mit dem Signalausgang des Kammgenerators 14 elektrisch leitend verbunden. Das zweite elektrische Verbindungselement 10 ist gegenüber dem zweiten mechanischen Verbindungselement 8 isoliert bzw. kontaktfrei angeordnet. In diesem Ausführungsbeispiel weist das zweite elektrische Verbindungselement 10 eine Steckausnehmung zur Aufnahme eines Steckzapfens auf. Das zweite elektrische Verbindungselement 10 ist an den Innenleiter des Signalkabels 31 angeschlossen. Das zweite elektrische Verbindungselement 10 ist gegenüber dem zweiten mechanischen Verbindungselement 8 elektrisch isoliert in einer im mechanischen Verbindungselement 8 vorgesehenen Ausnehmung 81 achssymmetrisch angeordnet.

Figur 4 zeigt einen Schnitt des ersten Antennenteils 4, wobei die in Figur 6 dargestellte Schnittebene I-I die Symmetrieachse A umfasst. Der erste Antennenteil 4 umfasst den ersten Hohlkegel 2 sowie den Verbindungsteil 5. Der Verbindungsteil 5 fungiert als mechanisches Verbindungselement 7 bzw. ist als solches ausgebildet und besitzt insbesondere eine Rastausnehmung oder ein Innengewinde. Das erste mechanische Verbindungselement 7 ist an das zweite mechanische Verbindungselement 8 angepasst, wodurch die beiden Antennenteile 4, 6 dreh- und bewegungsfest miteinander verbindbar sind.

Im Verbindungsteil 5 ist eine zylindrische Ausnehmung 11 für einen Kontaktstift 12 vorgesehen. Der Kontaktstift 12 ist hierbei gegenüber dem Verbindungsteil 5 isoliert bzw. kontaktfrei angeordnet. Der Kontaktstift 12 ist durch die Ausnehmung 11 hindurch geführt und elektrisch leitend mit dem ersten Hohlkegel 2 verbunden. In diesem Ausführungsbeispiel ist vorgesehen, dass der erste Hohlkegel 2 eine Aufnahmeöffnung 20 für den Kontaktstift 12 aufweist, in welche dieser Kontaktstift 12 eingebracht, insbesondere eingepresst, werden kann. Es kann jedoch auch vorgesehen sein, dass der Kontaktstift 12 lösbar mit dem ersten Hohlkegel 2 verbunden ist. Auf dem dem ersten Hohlkegel 2 fernen Endbereich des Kontaktstiftes 12 ist ein Verbindungszapfen angeordnet, welcher als erstes elektrisches Verbindungselement 9 fungiert. Dieser Verbindungszapfen ist an die Verbindungsausnehmung des zweiten elektrischen Verbindungselements 10 angepasst bzw. bei Zusammenfügen der beiden Antennenteile 4, 6 mit diesem in Kontakt bringbar.

Der Verbindungsteil 5 ist jener Teil des ersten Antennenteils 4, welcher den scheitelpunktnahen Teil des zweiten Hohlkegels 3 bildet. Dieser Verbindungsteil 5 kann an seiner dem zweiten Antennenteil 6 zugewandten Seite einen Stecker oder eine Buchse aufweisen, welche(r) als erstes mechanisches Verbindungselement 7 und gegebenenfalls auch als erstes elektrisches Verbindungselement 9 fungiert. Ferner kann der Verbindungsteil 5 auch selbst als Verbindungselement, insbesondere als erstes mechanisches Verbindungselement 7 ausgebildet sein, wobei vorzugsweise eine Ausnehmung zur Aufnahme des zweiten mechanischen Verbindungselements 8 in den Körper des Verbindungsteils vorgesehen, insbesondere eingefräst ist.

Zur Erhöhung der Stabilität sind die scheitelnahen Endbereiche der beiden Hohlkegel 2, 3 zylindrisch ausgestaltet. Im scheitelnahen Endbereich der beiden Hohlkegel 2, 3 ist ein Halterungselement 13, insbesondere aus Kunststoff, zur Erhöhung der Stabilität der Antenne 1 vorgesehen. Die Innenform des Halterungselements 13 ist an die Außenform der beiden Hohlkegel 2, 3 angepasst bzw. entspricht dieser. Das Halterungselement 13 liegt mit seiner Innenfläche an den beiden Hohlkegeln 2, 3 an und weist die Außenform eines Zylindermantels auf.

Wie in Fig. 7 gezeigt, kann das Halterungselement 13 auch als ein nicht leitendes Element ausgebildet sein, welches mit seiner den Hohlkegeln 2, 3 zugewandten Innenseite an diesen Hohlkegeln 2, 3 anliegt und an seiner Außenseite durch eine Vielzahl von kreiszylindrischen, insbesondere parallel zur Kegelachse A verlaufenden, Stützzylindern 52 mit, vorzugsweise gleichen, Abstand von der Kegelachse A, und vorzugsweise mit konstantem Abstand zweier benachbarter Stützzylinder 52 gestützt bzw. stabilisiert ist.

Beide Konstruktionsformen erhöhen die Stabilität der beiden Hohlkegel 2, 3 und verhindern das Verschwenken bzw. Verkippen der Hohlkegel 2, 3 im Bereich des Scheitelpunkts.

Wie in Figur 1 dargestellt, bilden die beiden Antennenteile 4, 6 eine Antenne 1. Die elektrische Kontaktierung der beiden Antennenteile 4, 6 wird mittels der elektrischen Verbindungselemente 9, 10, sowie der mechanischen Verbindungselemente 7, 8 erzielt. Die mechanischen Verbindungselemente 7, 8 sind als aneinander angepasste Schraub-, Steck- oder Rastverbindungen ausgebildet, welche bei entsprechender Verbindung die beiden Antennenteile 4, 6 zu einer Antenne mit, doppelt konischen Verlauf, eventuell mit Abweichungen im Bereich des Scheitelpunkts bilden.

Die Signalmasse des Signalkabels 31 ist an den zweiten mechanischen Verbindungselement 8 angeschlossen, welcher leitend mit dem Verbindungsteil 5, dem ersten mechanischen Verbindungselement 7 sowie der Mantelfläche oder Außenfläche des zweiten Antennenteils verbunden ist.

Die gesamte Oberfläche des ersten Hohlkegels 2 liegt auf dem Potential des vom Kammgenerators 14 erzeugten Signals. Der zweite Hohlkegel 3 liegt durch die Verbindung der mechanischen Verbindungselemente 7, 8, des Mantels des zweiten Antennenteiles 6 sowie des Mantels des Verbindungsteils 5 auf Massepotenzial.

Figur 5 zeigt die Führung des Kontaktstiftes 12 im scheitelpunktnahen Bereich der beiden Hohlkegel 2, 3. Zur gegenseitigen Isolierung der beiden Hohlkegel 2, 3 ist ein isolierender Ring 17 vorgesehen, welcher die beiden Hohlkegel 2, 3 in einem vordefinierten Abstand zueinander hält. Um einen Kurzschluss zwischen dem Verbindungsteil 5 und dem Kontaktstift 12 zu verhindern, ist an der Wandfläche der zylindrischen Ausnehmung 11 für den Kontaktstift 12 im Verbindungsteil 5 eine gegenüber dem Kontaktstift 12 isolierende Oberflächenbeschichtung 18 bzw. ein isolierender Hohlzylinder 18 vorgesehen. Selbstverständlich kann die isolierende Schicht auch mit dem Kontaktstift 12 verbunden sein bzw. diesen umgeben.

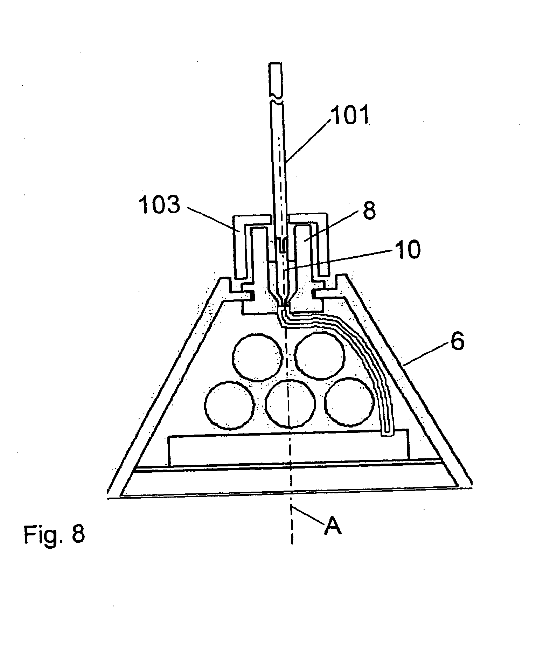

Figur 8 zeigt eine Antenne 1 umfassend den zweiten Antennenteil 6 sowie ein zweites elektrisches Verbindungselement 10, sowie ein zweites mechanisches Verbindungselement 8. Ein Antennenelement 101 ist mit dem zweiten elektrischen Verbindungselement 10 leitend verbunden. Dieses Antennenelement 101 ist als zylindrischer Metallstab gebildet. In dem dem zweiten elektrischen Verbindungselement 10 zugewandten Endbereich des Antennenelements 101 ist ein Stecker 103 vorgesehen, welche an das mechanische Verbindungselement 8 angepasst ist und mit diesem in Verbindung gebracht ist. Der Stecker 103 weist eine Durchführungsöffnung 105 auf, durch welche das Antennenelement 101 hindurchgeführt ist. Im Bereich der Durchführungsöffnung 105 können selbstverständlich isolierende Elemente bzw. eine isolierende Oberflächenbeschichtung vorgesehen sein, welche einen Kurzschluss zwischen der Signalmasse, welche an das zweite mechanische Verbindungselement 8 angeschlossen ist und dem an das zweite elektrische Verbindungselement 10 angeschlossenen Antennensignal verhindert. Alternativ dazu kann vorgesehen werden, dass das Antennenelement 101 durch ein ungeschirmtes Koaxialkabel gebildet ist.

## Patentansprüche

1. Doppelt konische, achssymmetrische Antenne,
a) umfassend zwei gegeneinander isolierte Hohlkegel (2, 3), wobei
b) der Körper der Antenne (1) zwei Antennenteile (4, 6) umfasst,
c) wobei der erste Antennenteil (4) den ersten Hohlkegel (2) sowie einen an den ersten Hohlkegel (2) angrenzenden, als Verbindungsteil (5) fungierenden Abschnitt des zweiten Hohlkegels (3) umfasst, und
d) der zweite Antennenteil (6) den übrigen kegelstumpfförmigen Teil des zweiten Hohlkegels (3) umfasst und der Verbindungsteil (5) und der zweite Antennenteil (6), miteinander verbunden sind,
**dadurch gekennzeichnet, dass** der Verbindungsteil (5) die Außenform eines Kegels aufweist und den zweiten Antennenteil (6) kegelstumpfförmig verlängert bzw. fortsetzt.

2. Antenne nach Anspruch 1, **dadurch gekennzeichnet,**
- **dass** an jedem der beiden Antennenteile (4, 6) je eines von zwei elektrischen Verbindungselemente (9, 10) angeordnet ist, wobei das erste elektrische Verbindungselement (9) elektrisch leitend mit dem zweiten elektrischen Verbindungselement (10) sowie mit dem Mantel des ersten Hohlkegels (2) verbunden ist und/oder
- **dass** an jedem der beiden Antennenteile (4, 6) mechanische Verbindungselemente (7, 8) vorgesehen sind, welche die beiden Antennenteile (4, 6) in ihrer gegenseitigen Position zueinander festlegen und/oder
- **dass** die mechanischen Verbindungselemente (7, 8) und/oder die elektrischen Verbindungselemente (9, 10) rotationssymmetrisch bezüglich der Achse der Hohlkegel (2, 3) aufgebaut sind.

3. Antenne gemäß Anspruch 2, **dadurch gekennzeichnet,**
- **dass** die mechanischen Verbindungselemente (7, 8) an den einander zugewandten Flächen bzw. Seiten der Antennenteile (4, 6) angeordnet sind und gegebenenfalls als aneinander angepasste Schraubverbindungen mit Innen- bzw. Außengewinde ausgebildet sind und/oder
- **dass** die mechanischen Verbindungselemente (7, 8) als Rastverbindung mit Rastelement und Rastausnehmung ausgebildet sind und/oder
- **dass** der zweite Antennenteil (6), die mechanischen Verbindungselemente (7, 8) und der Verbindungsteil (5) elektrisch leitend verbunden sind.

4. Antenne gemäß einem der Ansprüche 1 bis 3, **dadurch gekennzeichnet,**
- **dass** der Verbindungsteil (5) als Stecker oder Buchse zur Leitung eines elektrischen Signals sowie zur Verbindung eines Massekontakts und zur mechanischen Verbindung der beiden Antennenteile (4, 6) ausgestaltet ist und/oder
- **dass** der Verbindungsteil (5) als Verrastteil oder als Rastausnehmung gebildet ist und der am Verbindungsteil (5) anliegenden Seite des zweiten Antennenteils (6) ein an den Verbindungsteil (5) angepasster Verrastteil oder eine entsprechende Rastausnehmung angeordnet bzw. ausgebildet ist und/oder
- **dass** der Verbindungsteil (5) als Schraubstecker, insbesondere mit Außengewinde, oder als an das als Schraubstecker ausgebildete zweite mechanische Verbindungselement (8) angepasste Buchse, insbesondere mit Innengewinde, gebildet ist, und dass an der am Verbindungsteil (5) anliegenden Seite des zweiten Antennenteils (6) eine an den Verbindungsteil (5) angepasste Buchse oder ein entsprechender Schraubstecker angeordnet bzw. ausgebildet ist.

5. Antenne gemäß einem der Ansprüche 1 bis 4, **dadurch gekennzeichnet,**
- **dass** die beiden aneinander anliegenden oder angrenzenden Flächen der beiden Antennenteile (4, 6) zur Deckung gebracht sind und insbesondere kreisförmig und/oder mit gleich großer End- bzw. Querschnittsfläche ausgebildet sind.

6. Antenne gemäß einem der Ansprüche 2 bis 5, **dadurch gekennzeichnet,**
- **dass** die elektrischen Verbindungselemente (9, 10) als zwei miteinander verbindbare , insbesondere metallische und/oder zylindrische, Leiterelemente ausgebildet sind, welche insbesondere koaxial bezüglich der Kegelachse (A) und/oder direkt um die Kegelachse (A) angeordnet sind und gegenüber dem zweiten Antennenteil (6) isoliert sind.

7. Antenne gemäß einem der Ansprüche 1 bis 6, **dadurch gekennzeichnet,**
- **dass** die beiden Hohlkegel (2, 3) im Bereich des gemeinsamen Scheitelpunkts (19) eine von der Kegelgestalt abweichende Außenform aufweisen, und in diesem Bereich insbesondere zylindrische Form oder die Form eines Drehhyperboloids aufweisen.

8. Antenne gemäß einem der Ansprüche 2 bis 7, **dadurch gekennzeichnet,**
- **dass** im scheitelpunktnahen Endbereich der beiden Hohlkegel (2, 3) eine durchgehende Ausnehmung (11) parallel zur Symmetrieachse (A) der Antenne (1) zur Durchführung eines leitfähigen zylindrischen Kontaktstiftes (12) vorgesehen ist,
- **dass** das erste elektrische Verbindungselement (9) als Kontaktstift (12) ausgebildet ist, insbesondere aus Metall gebildet ist, durch die Ausnehmung (11) durchgeführt ist, mit dem Mantel des ersten Hohlkegels (2) elektrisch leitend verbunden und gegenüber dem zweiten Hohlkegel (3) isoliert ist,
- **dass** der Kontaktstift (12) an seinem dem zweiten elektrischen Verbindungselement (10) zugewandten Ende mit dem am zweiten Antennenteil (6) angeordneten elektrischen Verbindungselement (10) elektrisch leitend verbindbar ist, und
- **dass** gegebenenfalls das zweite elektrische Verbindungselement (10) einen angepassten Endbereich, insbesondere eine angepasste Ausnehmung, aufweist, wobei gegebenenfalls an der Wand der Ausnehmung (11) des ersten Hohlkegels (2) eine Isolierungsbeschichtung (18) oder ein isolierender Hohlzylinder (18) angeordnet ist, und/oder im Bereich zwischen den beiden Hohlkegeln (2, 3) Isoliermaterial, insbesondere ein isolierender, vorzugsweise zylindrischer, Ring (17), insbesondere aus Kunststoff, angeordnet ist, und/oder die beiden einander zugewandten Flächen der beiden Hohlkegel (2, 3) isolierend beschichtet oder mit einer Isolierschicht (17) getrennt sind und/oder im Außenbereich des scheitelpunktnahen Endbereichs der beiden Hohlkegel (2, 3) ein Halterungselement, insbesondere aus Kunststoff, (13) zur Erhöhung der Stabilität der Antenne vorgesehen ist, welches eine Innenform aufweist, welche der Außenform der Hohlkegel (2, 3) entspricht, und an den beiden Hohlkegeln anliegt, wobei gegebenenfalls die Außenform des Halterungselements (13) einem Zylindermantel entspricht und/oder der Durchmesser des zylindrischen Halterungselements (13) im Bereich zwischen dem doppelten bis fünffachen Durchmesser des minimalen Durchmessers des scheitelpunktnahen Endbereichs eines der beiden Hohlkegel (2, 3) liegt.

9. Antenne gemäß einem der Ansprüche 2 bis 8, **dadurch gekennzeichnet, dass** im zweiten Antennenteil (6) ein Kammgenerator (14) zur Erzeugung eines Antennensignals angeordnet ist, wobei gegebenenfalls Batterien (15) zur Stromversorgung des Kammgenerators (14) im zweiten Antennenteil (6), insbesondere im scheitelpunktnahen Innenbereich des zweiten Hohlkegels (3), angeordnet sind und/oder der Signalausgang (21) des Kammgenerators (14) an das zweite elektrische Verbindungselement (10) angeschlossen ist, und das Massesignal des Kammgenerators (14) an den zweiten Antennenteil (6), an eines und/oder beide mechanischen Verbindungselemente (7, 8) und/oder an den Verbindungsteil (5) angeschlossen ist bzw. mit zumindest einem dieser Elemente (5, 6, 7, 8) verbunden ist.

10. Antenne gemäß Anspruch 9, **dadurch gekennzeichnet, dass** der Kammgenerator (14) auf einer, insbesondere kreisförmigen, an den Innendurchmesser des zweiten Hohlkegels (3) angepassten, Platine (16) angeordnet ist, welche im Inneren des zweiten Hohlkegels (3), insbesondere an der Innenseite des zweiten Hohlkegels (3), befestigt ist.

11. Antenne gemäß einem der Ansprüche 9 oder 10, **dadurch gekennzeichnet,**
- **dass** der das erste elektrische Verbindungselement (9) bildende Kontaktstift (12) mit dem ersten Antennenteil (4), insbesondere dem ersten Hohlkegel (2), und/oder mit dem zweiten elektrischen Verbindungselement (10) lösbar verbindbar und/oder elektrisch kontaktierbar ist.

12. Antenne gemäß einem der vorangegangenen Ansprüche, **dadurch gekennzeichnet, dass** der Verbindungsteil (5) und der zweite Antennenteil (6) lösbar, insbesondere verschraubbar, miteinander verbunden sind.

## Claims

1. A biconical, axially symmetrical antenna,
a) comprising two hollow cones (2, 3) insulated from one another,
b) the body of said antenna (1) comprising two antenna sections (4, 6),
c) the first antenna section (4) comprising the first hollow cone (2) and a section of the second hollow cone (3), which is adjacent to said first hollow cone (2) and serves as a joining element (5), and
d) the second antenna section (6) comprising the remaining truncated part of said second hollow cone (3) and said joining element (5) and said second antenna section (6) being connected to one another,
**characterised in that** said joining element (5) has a conical external shape and forms a truncated conical extension or continuation of said second antenna section (6).

2. The antenna according to claim 1, **characterised**
- **in that**, on each of the two antenna sections (4, 6), one of two electrical connecting members (9, 10) is arranged, the first electrical connection element (9) being connected in an electrically conductive manner to the second electrical connection element (10) as well as to the surface of the first hollow cone (2), and/or
- **in that** mechanical connecting members (7, 8) are provided on each of the two antenna sections (4, 6), said mechanical connecting members (7, 8) fixing the two antenna sections (4, 6) in their positions relative to one another, and/or
- **in that** said mechanical connecting members (7, 8) and/or said electrical connecting members (9, 10) are arranged rotationally symmetrical in relation to the axis of the hollow cone (2, 3).

3. The antenna according to claim 2, **characterised**
- **in that** said mechanical connecting members (7, 8) are arranged on the surfaces or sides of said antenna sections (4, 6) which face each other and are optionally formed as fitting screw connections, respectively having an internal or an external thread, and/or
- **in that** said mechanical connecting members (7, 8) are formed as locking connections, respectively having a locking element or a locking recess, and/or
- **in that** the second antenna section (6), the mechanical connecting members (7, 8), and the joining element (5) are connected in an electrically conductive manner.

4. The antenna according to any one of the claims 1 to 3, **characterised**
- **in that** the joining element (5) is formed as a plug or socket for conducting an electrical signal and for connecting a ground contact and for mechanically connecting the two antenna sections (4, 6), and/or
- **in that** the joining element (5) is formed as a locking part or a locking recess and a locking part or a corresponding locking recess adapted to the joining element (5) is arranged or formed on the side of the second antenna part (6) which is adjacent to the joining element (5), and/or
- **in that** the joining element (5) is formed as a screw plug, especially having an external thread, or as a socket adapted to the second mechanical connecting member (8) formed as a screw plug and especially having an internal thread, and in that a socket or a corresponding screw plug adapted to the joining element (5) is arranged or formed on the side of the second antenna part (6) which is adjacent to the joining element (5).

5. The antenna according to any one of the claims 1 to 4, **characterised**
- **in that** the two adjacent surfaces of the two antenna sections (4, 6) are aligned to be congruent and are formed to be especially circular and/or to have end faces or cross-sectional areas of the same size.

6. The antenna according to any one of the claims 2 to 5, **characterised**
- **in that** the electrical connecting members (9, 10) are formed as two, especially metallic and/or cylindrical, conducting elements which are connectable to one another and which are arranged to be especially coaxial in relation to the cone's axis (A) and/or directly around the cone's axis (A) and insulated from the second antenna section (6).

7. The antenna according to any one of the claims 1 to 6, **characterised**
- **in that** the two hollow cones (2, 3) have an external shape deviating from the conical shape in the area of their common apex (19) and, in this area, especially have the shape of a cylinder or a paraboloid of revolution.

8. The antenna according to any one of the claims 2 to 7, **characterised**
- **in that** a continuous recess (11) for inserting a conductive cylindrical contact pin (12) is provided in parallel to the symmetrical axis (A) of the antenna (1) in the end areas of the two hollow cones (2, 3) close to the apex,
- **in that** the first electrical connecting member (9) is formed as a contact pin (12), especially from metal, is inserted through the recess (11), connected in an electrically conductive manner to the surface of the first hollow cone (2) and insulated from the second hollow cone (3),
- **in that**, at its end facing the second electrical connecting member (10), the contact pin (12) is connectable in an electrically conductive manner to the electrical connecting element (10) arranged on the second antenna part (6), and
- **in that** the second electrical connecting member (10) optionally has an adapted end area, especially an adapted recess, an insulating coating (18) or an insulating hollow cylinder (18) being optionally arranged on the wall of the recess (11) of the first hollow cone (2), and/or insulating material, especially an insulating, preferably cylindrical, ring (17), especially made of plastic, being arranged in the area between the two hollow cones (2, 3), and/or the two surfaces of the two hollow cones (2, 3), which face each other, being coated with an insulating coating or separated by an insulating layer (17), and/or a mounting member (13), especially made of plastic, for increasing the antenna's stability being provided in the outer area of the end area of the two hollow cones (2, 3) close to the apex, said mounting member having an internal shape corresponding to the external shape of the hollow cones (2, 3) and being adjacent to the two hollow cones, the external shape of the mounting member (13) optionally corresponding to the surface of a cylinder and/or the diameter of the cylindrical mounting member (13) being in the range of 2 two 5 times the minimal diameter of the end area of one of the two hollow cones (2, 3) close to the apex.

9. The antenna according to any one of the claims 2 to 8, **characterised in that** a comb generator (14) for generating an antenna signal is arranged in the second antenna section (6), batteries (15) for supplying energy to the comb generator (14) being optionally arranged in the second antenna section (6), especially in the inner area of the second hollow cone (3) close to the apex, and/or the signal output (21) of the comb generator (14) being connected to the second electrical connecting member (10), and the ground signal of the comb generator (14) being connected to the second antenna section (6), to one and/or both of the two mechanical connecting members (7, 8), and/or to the joining element (5) or being connected to at least one of these elements (5, 6, 7, 8).

10. The antenna according to claim 9, **characterised in that** the comb generator (14) is arranged on a circuit board (16) which is especially circular and adapted to the inner diameter of the second hollow cone (3), said circuit board (16) being mounted in the interior of the second hollow cone (3), especially to the inner surface of the second hollow cone (3).

11. The antenna according to claim 9 or claim 10, **characterised**
- **in that** the contact pin (12) forming the first electrical connecting member (9) is releasably connectable and/or electrically contactable with the first antenna section (4), especially with the first hollow cone (2), and/or with the second electrical connecting element (10).

12. The antenna according to any one of the preceding claims, **characterised in that** the joining element (5) and the second antenna section (6) are releasably connected to each other, especially by a screw connection.

## Revendications

1. Antenne biconique, symétrique par rapport à un axe,
a) comprenant deux cônes creux (2, 3), isolés l'un par rapport à l'autre,
b) le corps de ladite antenne (1) comprenant deux parties d'antenne (4, 6),
c) la première partie (4) de l'antenne comprenant le premier cône creux (2) ainsi qu'une section du deuxième cône creux (3) adjacente au premier cône creux (2) et servant de raccord (5), et
d) la deuxième partie (6) de l'antenne comprenant la section tronconique restante du deuxième cône creux (3), et le raccord (5) et la deuxième partie (6) de l'antenne étant reliés,
**caractérisée en ce que** le raccord (5) est d'une forme extérieure conique et est une extension ou une continuation tronconique de la deuxième partie (6) de l'antenne.

2. Antenne selon la revendication 1, **caractérisée**
- **en ce que** respectivement un de deux éléments de raccord électriques (9, 10) est disposé sur chacune des deux parties (4, 6) de l'antenne, le premier élément de raccord électrique (9) étant relié de manière électroconductrice au deuxième élément de raccord électrique (10) ainsi qu'à la surface du premier cône creux (2), et/ou
- **en ce que** des éléments de raccord mécaniques (7, 8) sont prévus sur chacune des deux parties (4, 6) de l'antenne, lesdits éléments de raccord mécaniques fixant les deux parties (4, 6) de l'antenne dans leurs positions respectives l'une par rapport à l'autre, et/ou
- **en ce que** les éléments de raccord mécaniques (7, 8) et/ou les éléments de raccord électriques (9, 10) sont disposés à symétrie de révolution par rapport à l'axe des cônes creux (2, 3).

3. Antenne selon la revendication 2, **caractérisée**
- **en ce que** les éléments de raccord mécaniques (7, 8) sont disposés sur les faces ou sur les côtés des parties (4, 6) de l'antenne en face l'une de l'autre et sont, selon le cas, formés comme des raccords vissés adaptés l'un à l'autre, l'un ayant un filet intérieur, l'autre ayant un filet extérieur, et/ou
- **en ce que** les éléments de raccord mécaniques (7, 8) sont formés comme un raccord d'encliquetage avec un élément à encliqueter et un creux d'enclenchement, et/ou
- **en ce que** la deuxième partie (6) de l'antenne, les éléments de raccord mécaniques (7, 8) et le raccord (5) sont reliés de manière électroconductrice.

4. Antenne selon l'une des revendications 1 à 3, **caractérisée**
- **en ce que** le raccord (5) est formé comme une fiche ou une prise pour transmettre un signal électrique et pour raccorder un contact à la masse ainsi que pour relier les deux parties (4, 6) de l'antenne de manière mécanique, et/ou
- **en ce que** le raccord (5) est formé comme un élément à encliqueter ou un creux d'enclenchement et un élément à encliqueter adapté au raccord (5) ou un creux d'enclenchement correspondant est disposé ou formé sur le côté adjacent au raccord de la deuxième partie (6) de l'antenne, et/ou
- **en ce que** le raccord (5) est formé comme une fiche à visser, notamment ayant un filet extérieur, ou comme une prise adaptée au deuxième élément de raccord mécanique (8) en forme de fiche à visser et en ce qu'une prise adaptée au raccord (5) ou une fiche à visser correspondante est disposée ou formée sur le côté de la deuxième partie (6) adjacent au raccord de l'antenne.

5. Antenne selon l'une des revendications 1 à 4, **caractérisée**
- **en ce que** les deux faces adjacentes des deux parties (4, 6) de l'antenne sont aménagées pour être coïncidentes et sont notamment circulaires et/ou leurs surfaces terminales ou les surfaces de leurs sections sont équivalentes en dimension.

6. Antenne selon l'une des revendications 2 à 5, **caractérisée**
- **en ce que** les éléments de raccord électriques (9, 10) sont formés comme deux éléments conducteurs, notamment métalliques et/ou cylindriques, qui peuvent être reliés l'un à l'autre et qui sont disposés notamment de manière coaxiale par rapport à l'axe des cônes (A) et/ou directement autour de l'axe des cônes (A) et qui sont isolés par rapport à la deuxième partie (6) de l'antenne.

7. Antenne selon l'une des revendications 1 à 6, **caractérisée**
- **en ce que**, dans le domaine de leur sommet commun (19), les deux cônes creux (2, 3) ont une forme extérieure déviant de la forme conique et, dans ledit domaine, notamment ont une forme cylindrique ou la forme d'un hyperboloïde de révolution.

8. Antenne selon l'une des revendications 2 à 7, **caractérisée**
- **en ce que**, dans la partie terminale des deux cônes creux (2, 3), près du sommet, un creux continu (11) est prévu parallèlement à l'axe de symétrie (A) de l'antenne (1) pour insérer une fiche de contact (12) conductrice cylindrique,
- **en ce que** le premier élément de raccord électrique (9) est formé comme une fiche de contact (12), notamment de métal, inséré à travers le creux (11), relié de manière électroconductrice à la surface du premier cône creux (2) et isolé par rapport au deuxième cône creux (3),
- **en ce que**, par son bout orienté vers le deuxième élément de raccord électrique (10), la fiche de contact (12) peut être reliée de manière électroconductrice à l'élément de raccord électrique (10) disposé sur la deuxième partie de l'antenne (6), et
- **en ce que**, selon le cas, le deuxième élément de raccord électrique (10) a une partie terminale adaptée, notamment un creux adapté, un revêtement isolant (18) ou un cylindre creux isolant (18) étant éventuellement disposé sur la paroi du creux (11 ) du premier cône creux (2), et/ou de la matière isolante, notamment un anneau isolant (17), de préférence cylindrique, notamment en matière synthétique, étant disposée dans le domaine entre les deux cônes creux (2, 3), et/ou les deux faces des deux cônes creux (2, 3) en face l'une de l'autre ayant un revêtement isolant ou étant séparées par une couche isolante (17), et/ou en ce que un élément de fixation (13), notamment en matière synthétique, pour améliorer la stabilité de l'antenne est prévu dans le domaine extérieur de la partie terminale près du sommet, ledit élément de fixation (13) ayant une forme intérieure correspondante à la forme extérieure des cônes creux (2, 3) et étant adjacent aux deux cônes creux, la forme extérieure de l'élément de fixation (13) correspondant, selon le cas, à une surface cylindrique et/ou le diamètre de l'élément de fixation (13) cylindrique correspondant à deux à cinq fois le diamètre minimal de la partie terminale près du sommet d'un des deux cônes creux (2, 3).

9. Antenne selon l'une des revendications 2 à 8, **caractérisée en ce qu'**un générateur de peigne (14) pour la génération d'un signal d'antenne est disposé dans la deuxième partie (6) de l'antenne, des batteries pour alimenter le générateur de peigne (14) en courant étant éventuellement disposées dans la deuxième partie (6) de l'antenne dans le domaine intérieur, près du sommet, du deuxième cône creux (3), et/ou la sortie des signaux (21) du générateur de peigne (14) étant reliée au deuxième élément de raccord électrique (10), et/ou le signal de masse du générateur de peigne (14) étant relié à la deuxième partie (6) de l'antenne, à l'un des deux et/ou aux deux éléments de raccord mécaniques (7, 8) et/ou au raccord (5) ou étant relié à au moins un desdits éléments (5, 6, 7, 8).

10. Antenne selon la revendication 9, **caractérisée en ce que** le générateur de peigne (14) est disposé sur une carte de circuit (16) qui est notamment circulaire et adaptée au diamètre intérieur du deuxième cône creux (3) et qui est fixée à l'intérieur du deuxième cône creux (3), notamment sur le côté intérieur du deuxième cône creux (3).

11. Antenne selon la revendication 9 ou 10, **caractérisée**
- **en ce que** la fiche de contact (12) formant le premier élément de raccord électrique (9) peut être reliée de manière détachable à et/ou contactée électriquement avec la première partie (4) de l'antenne, notamment au/avec le premier cône creux (2), et/ou au/avec le deuxième élément de raccord électrique (10).

12. Antenne selon l'une des revendications précédentes, **caractérisée en ce que** le raccord (5) et la deuxième partie (6) de l'antenne sont reliés de manière détachable, notamment de manière vissé.
